# EUROPÄISCHE PATENTANMELDUNG

(11) **EP 2 998 048 A1**
(43) Veröffentlichungstag der Anmeldung: **23.03.2016**
(21) Anmeldenummer: 14185159.2
(22) Anmeldetag: 17.09.2014
(51) Int. Cl.: B22F 1/00, B22F 7/06, B23K 35/34, H01L 23/00

(54) **Metallsinterzubereitung und deren Verwendung zum Verbinden von Bauelementen**

(71) Anmelder: Heraeus Deutschland GmbH & Co. KG, 63450 Hanau (DE)
(72) Erfinder: Nachreiner, Jens, 36381 Schlüchtern (DE); Schäfer, Michael, 36093 Künzell (DE)
(74) Vertreter: Heraeus IP

(57) **Zusammenfassung**

Metallsinterzubereitung, die (A) 50 bis 90 Gew.-% wenigstens eines Metalls, das in Form von Partikeln vorliegt, die ein Coating aufweisen, das wenigstens eine organische Verbindung enthält, und (B) 6 bis 50 Gew.-% eines Gemischs mindestens zweier organischer Lösemittel umfasst, dadurch gekennzeichnet, dass das Lösemittelgemisch (B) 30 bis ≤ 70 Gew.-% Adipinsäuredimethylester als eines der organischen Lösemittel und weniger als 30 Gew.-% Glutarsäuredimethylester plus Bernsteinsäuredimethylester enthält.

## Beschreibung

Die vorliegende Erfindung betrifft eine Metallsinterzubereitung und ein Verfahren zum Verbinden von Bauelementen, bei dem diese Metallsinterzubereitung eingesetzt wird.

Im Bereich der Leistungs- und Konsumerelektronik stellt das Verbinden von Bauelementen, wie LEDs oder sehr dünnen Siliziumchips, die eine hohe Druck- und Temperaturempfindlichkeit aufweisen, eine besondere Herausforderung dar.

Aus diesem Grund werden solche druck- und temperaturempfindlichen Bauelemente häufig durch Kleben miteinander verbunden. Die Klebetechnik besitzt jedoch den Nachteil, dass damit Kontaktstellen zwischen den Bauelementen geschaffen werden, die eine nur unzureichende Wärmeleitfähigkeit bzw. elektrische Leitfähigkeit aufweisen.

Um dieses Problem zu lösen, werden die zu verbindenden Bauelemente häufig gesintert. Die Sintertechnik stellt ein sehr einfaches Verfahren zum stabilen Verbinden von Bauelementen dar.

Der Einsatz von Metallsinterzubereitungen in einem Sinterprozess zum Verbinden von Bauelementen im Bereich der Leistungselektronik ist bekannt. Beispielsweise offenbart WO2011/026623 A1 eine Metallsinterpaste enthaltend 75 bis 90 Gew.-% (Gewichtsprozent) wenigstens eines Metalls, das in Form von Partikeln vorliegt, die ein Coating aufweisen, das wenigstens eine organische Verbindung enthält, 0 bis 12 Gew.-% wenigstens eines Metallprecursors, 6 bis 20 Gew.-% wenigstens eines Lösemittels und 0,1 bis 15 Gew.-% wenigstens eines Sinterhilfsmittels, sowie die Verwendung der Metallsinterzubereitung zur Verbindung von Bauelementen mittels eines Sinterverfahrens.

Aufgabe der Erfindung ist die Bereitstellung eines Sinterverfahrens zur stabilen Verbindung von Bauelementen. Mit dem Verfahren sollen Kontaktstellen zwischen den zu verbindenden Bauelementen gebildet werden, die eine niedrige Porosität und eine hohe elektrische und thermische Leitfähigkeit aufweisen. Eine weitere Aufgabe der vorliegenden Erfindung besteht darin, eine zur Durchführung eines derartigen Sinterverfahrens geeignete Metallsinterzubereitung bereitzustellen

Unter der Bezeichnung "Dibasische Ester" ist ein Lösemittelgemisch aus 10 - 25 Gew.-% Adipinsäuredimethylester, 55 - 65 Gew.-% Glutarsäuredimethylester und 15 - 25 Gew.-% Bernsteinsäuredimethylester (CAS No. 95481-62-2) bekannt, kommerziell unter anderem unter der Bezeichnung COASOL™ von DOW erhältlich. Es ist bekannt, dieses Lösemittelgemisch als Bestandteil des Lösemittelanteils in Metallsinterzubereitungen zu verwenden. Die Anmelderin hat nun festgestellt, dass eine Verschiebung im Verhältnis dieser Dimethylester zugunsten des Adipinsäuredimethylester-Anteils bis hin zum Verzicht auf die Anwesenheit von Glutarsäuredimethylester und Bernsteinsäuredimethylester innerhalb des Lösemittelanteils in Metallsinterzubereitungen bei Verwendung letzterer zur Verbindung von Bauelementen überraschenderweise zur Bildung festerer Sinterverbindungen führt.

Die Erfindung betrifft ein Verfahren zum Verbinden von Bauelementen, bei dem man (a) eine Sandwichanordnung bereitstellt, die wenigstens (a1) ein Bauelement 1, (a2) ein Bauelement 2 und (a3) eine Metallsinterzubereitung aufweist, die sich zwischen Bauelement 1 und Bauelement 2 befindet, und (b) die Sandwichanordnung sintert, wobei die Metallsinterzubereitung (A) 50 bis 90 Gew.-% wenigstens eines Metalls, das in Form von Partikeln vorliegt, die ein Coating aufweisen, das wenigstens eine organische Verbindung enthält, und (B) 6 bis 50 Gew.-% eines Gemischs mindestens zweier organischer Lösemittel umfasst, dadurch gekennzeichnet, dass das Lösemittelgemisch (B) 30 bis ≤ 70 Gew.-%, bevorzugt 30 bis ≤ 65 Gew.-% Adipinsäuredimethylester als eines der organischen Lösemittel und weniger als 30 Gew.-%, bevorzugt weniger als 15 Gew.-% und insbesondere 0 Gew.-% Glutarsäuredimethylester plus Bernsteinsäuredimethylester enthält.

Der in der Beschreibung und den Ansprüchen verwendete Wortlaut "Glutarsäuredimethylester plus Bernsteinsäuredimethylester" bezieht sich auf die Summe von Glutarsäuredimethylester und Bernsteinsäuredimethylester, wobei sich drei Fälle unterscheiden lassen: (1) Glutarsäuredimethylester, kein Bernsteinsäuredimethylester, (2) Bernsteinsäuredimethylester, kein Glutarsäuredimethylester und (3) Bernsteinsäuredimethylester und Glutarsäuredimethylester, oder (1) - (3) zusammenfassend Glutarsäuredimethylester und/oder Bernsteinsäuredimethylester.

Die Erfindung betrifft ferner eine Metallsinterzubereitung, die (A) 50 bis 90 Gew.-% wenigstens eines Metalls, das in Form von Partikeln vorliegt, die ein Coating aufweisen, das wenigstens eine organische Verbindung enthält, und (B) 6 bis 50 Gew.-% eines Gemischs mindestens zweier organischer Lösemittel umfasst, dadurch gekennzeichnet, dass das Lösemittelgemisch (B) 30 bis ≤ 70 Gew.-%, bevorzugt 30 bis ≤ 65 Gew.-% Adipinsäuredimethylester als eines der organischen Lösemittel und weniger als 30 Gew.-%, bevorzugt weniger als 15 Gew.-% und insbesondere 0 Gew.-% Glutarsäuredimethylester plus Bernsteinsäuredimethylester enthält.

Die erfindungsgemäße Metallsinterzubereitung enthält 50 bis 90 Gew.-%, in einer ersten Ausführungsform beispielsweise 77 bis 89 Gew.-%, mehr bevorzugt 78 bis 87 Gew.-% und noch mehr bevorzugt 78 bis 86 Gew.-% und in einer zweiten Ausführungsform beispielsweise 50 bis 80 Gew.-%, und mehr bevorzugt 55 bis 75 Gew.-% wenigstens eines Metalls, das in Form von Partikeln vorliegt, die ein Coating aufweisen, das wenigstens eine organische Verbindung enthält. Die hier gemachten Gewichtsangaben schließen das Gewicht der Coatingverbindungen auf den Partikeln mit ein.

Unter den im Zusammenhang mit den gecoateten Metallpartikeln verwendeten Begriff "Metall" fallen sowohl reine Metalle als auch Metalllegierungen.

Im Rahmen der Erfindung bezieht sich der Begriff Metall auf Elemente, die im Periodensystem der Elemente in der selben Periode wie Bor, aber links von Bor, in der selben Periode wie Silizium, aber links von Silizium, in der selben Periode wie Germanium, aber links von Germanium, und in der selben Periode wie Antimon, aber links von Antimon stehen, sowie auf alle Elemente, die eine höhere Ordnungszahl als 55 aufweisen.

Als reine Metalle werden im Rahmen der Erfindung Metalle verstanden, die ein Metall mit einer Reinheit von wenigstens 95 Gew.-%, bevorzugt wenigstens 98 Gew.-%, mehr bevorzugt wenigstens 99 Gew.-% und noch mehr bevorzugt wenigstens 99,9 Gew.-% enthalten.

Gemäß einer bevorzugten Ausführungsform handelt es sich bei dem Metall um Kupfer, Silber, Gold, Nickel, Palladium, Platin oder Aluminium, insbesondere Silber.

Als Metalllegierungen werden metallische Gemische aus wenigstens zwei Komponenten verstanden, von denen wenigstens eine ein Metall ist.

Gemäß einer bevorzugten Ausführungsform wird als Metalllegierung eine Legierung eingesetzt, die Kupfer, Aluminium, Nickel und/oder Edelmetalle enthält. Die Metalllegierung umfasst vorzugsweise wenigstens ein Metall, das aus der Gruppe ausgewählt ist, die aus Kupfer, Silber, Gold, Nickel, Palladium, Platin und Aluminium besteht. Besonders bevorzugte Metalllegierungen enthalten wenigstens zwei Metalle, die aus der Gruppe ausgewählt sind, die aus Kupfer, Silber, Gold, Nickel, Palladium, Platin und Aluminium besteht. Es kann ferner bevorzugt sein, dass der Anteil der Metalle, die aus der Gruppe ausgewählt sind, die aus Kupfer, Silber, Gold, Nickel, Palladium, Platin und Aluminium besteht, an der Metalllegierung wenigstens 90 Gew.-%, vorzugsweise wenigstens 95 Gew.-%, und mehr bevorzugt wenigstens 99 Gew.-% beträgt. Bei der Legierung kann es sich beispielsweise um eine Legierung handeln, die Kupfer und Silber, Kupfer, Silber und Gold, Kupfer und Gold, Silber und Gold, Silber und Palladium, Platin und Palladium oder Nickel und Palladium enthält.

In der erfindungsgemäßen Metallsinterzubereitung können als Metall ein reines Metall, mehrere Arten von reinen Metallen, eine Art von Metalllegierung, mehrere Arten von Metalllegierungen oder Mischungen davon enthalten sein.

Das Metall liegt in der Metallsinterzubereitung in Form von Partikeln vor.

Die Metallpartikel können von unterschiedlicher Gestalt sein. Beispielsweise können die Metallpartikel in der Form von Flakes oder einer sphärischen (kugeligen) Form vorliegen. Gemäß einer besonders bevorzugten Ausführungsform weisen die Metallpartikel die Form von Flakes auf. Dies schließt jedoch nicht aus, dass von den eingesetzten Metallpartikeln auch ein untergeordneter Anteil eine andere Form aufweisen kann. Es ist jedoch bevorzugt, dass wenigstens 70 Gew.-%, mehr bevorzugt wenigstens 80 Gew.-%, noch mehr bevorzugt wenigstens 90 Gew.-% oder 100 Gew.-% der Partikel in der Form von Flakes vorliegen.

Die Metallpartikel sind gecoatet.

Unter einem Coating von Partikeln wird eine festhaftende Schicht auf der Oberfläche von Partikeln verstanden.

Das Coating der Metallpartikel enthält wenigstens eine Art von Coatingverbindungen.

Bei diesen Coatingverbindungen handelt es sich um organische Verbindungen.

Bei den organischen Verbindungen, die als Coatingverbindungen dienen, handelt es sich um kohlenstoffhaltige Verbindungen, die eine Agglomeration der Metallpartikel verhindern.

Gemäß einer bevorzugten Ausführungsform tragen die Coatingverbindungen wenigstens eine funktionelle Gruppe. Als funktionelle Gruppen kommen insbesondere Carbonsäuregruppen, Carboxylatgruppen, Estergruppen, Ketogruppen, Aldehydgruppen, Aminogruppen, Amidgruppen, Azogruppen, Imidgruppen oder Nitrilgruppen in Betracht. Bevorzugte funktionelle Gruppen sind Carbonsäuregruppen und Carbonsäureestergruppen. Die Carbonsäuregruppe kann deprotoniert sein.

Bei den Coatingverbindungen mit wenigstens einer funktionellen Gruppe handelt es sich vorzugsweise um gesättigte, einfach ungesättigte oder mehrfach ungesättigte organische Verbindungen.

Diese Coatingverbindungen mit wenigstens einer funktionellen Gruppe können ferner verzweigt oder unverzweigt sein.

Die Coatingverbindungen mit wenigstens einer funktionellen Gruppe weisen vorzugsweise 1 bis 50, mehr bevorzugt 2 bis 24, noch mehr bevorzugt 6 bis 24 und noch mehr bevorzugt 8 bis 20 Kohlenstoffatome auf.

Die Coatingverbindungen können ionisch oder nichtionisch sein.

Vorzugsweise kommen als Coatingverbindungen freie Fettsäuren, Fettsäuresalze oder Fettsäureester zum Einsatz.

Die freien Fettsäuren, Fettsäuresalze und Fettsäureester sind vorzugsweise unverzweigt.

Ferner sind die freien Fettsäuren, Fettsäuresalze oder Fettsäureester vorzugsweise gesättigt.

Bevorzugte Fettsäuresalze sind die Salze von Ammonium, Monoalkylammonium, Dialkylammonium, Trialkylammonium, Aluminium, Kupfer, Lithium, Natrium und Kalium.

Bevorzugte Ester sind Alkylester, insbesondere Methylester, Ethylester, Propylester und Butylester.

Gemäß einer bevorzugten Ausführungsform handelt es sich bei den freien Fettsäuren, Fettsäuresalzen oder Fettsäureestern um Verbindungen mit 8 bis 24, mehr bevorzugt 10 bis 24 und noch mehr bevorzugt 12 bis 18 Kohlenstoffatomen.

Bevorzugte Coatingverbindungen sind Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure), Lignocerinsäure (Tetracosansäure) sowie die entsprechenden Ester und Salze.

Besonders bevorzugte Coatingverbindungen sind Dodecansäure, Octadecansäure, Aluminiumstearat, Kupferstearat, Natriumstearat, Kaliumstearat, Natriumpalmitat und Kaliumpalmitat.

Die Coatingverbindungen können mittels herkömmlicher und aus dem Stand der Technik bekannter Verfahren auf die Oberfläche der Metallpartikel aufgetragen werden.

Beispielsweise ist es möglich, die Coatingverbindungen, insbesondere die vorstehend erwähnten Stearate oder Palmitate, in Lösemitteln aufzuschlämmen und die aufgeschlämmten Coatingverbindungen in Kugelmühlen mit den Metallpartikeln zu vermahlen. Nach dem Mahlen werden die mit den Coatingverbindungen beschichteten Metallpartikel getrocknet und anschließend entstaubt.

Vorzugsweise beträgt der Anteil an organischen Verbindungen, insbesondere der Anteil an Verbindungen, die aus der Gruppe ausgewählt sind, die aus freien Fettsäuren, Fettsäuresalzen und Fettsäureestern besteht, die vorzugsweise 8 bis 24, mehr bevorzugt 10 bis 24 und noch mehr bevorzugt 12 bis 18 Kohlenstoffatome aufweisen, an dem gesamten Coating wenigstens 60 Gew.-%, mehr bevorzugt wenigstens 70 Gew.-%, noch mehr bevorzugt wenigstens 80 Gew.-%, noch mehr bevorzugt wenigstens 90 Gew.-%, insbesondere wenigstens 95 Gew.-%, wenigstens 99 Gew.-% oder 100 Gew.-%.

Üblicherweise beträgt der Anteil der Coatingverbindungen, vorzugsweise der Coatingverbindungen, die aus der Gruppe ausgewählt sind, die aus freien Fettsäuren, Fettsäuresalzen und Fettsäureestern mit 8 bis 24, mehr bevorzugt 10 bis 24 und noch mehr bevorzugt 12 bis 18 Kohlenstoffatomen besteht, 0,01 bis 2 Gew.-%, vorzugsweise 0,3 bis 1,5 Gew.-%, bezogen auf das Gewicht der gecoateten Metallpartikel.

Der Coatinggrad, der als Verhältnis der Masse an Coatingverbindungen zur Oberfläche der Metallpartikel definiert ist, beträgt vorzugsweise 0,00005 bis 0,03 g, mehr bevorzugt 0,0001 bis 0,02 g an Coatingverbindungen pro Quadratmeter (m²) Oberfläche der Metallpartikel.

Die erfindungsgemäße Metallsinterzubereitung enthält 6 bis 50 Gew.-%, in der schon erwähnten ersten Ausführungsform beispielsweise 7 bis 25 Gew.-%, mehr bevorzugt 8 bis 20 Gew.-% und in der schon erwähnten zweiten Ausführungsform beispielsweise 15 bis 40 Gew.-%, mehr bevorzugt 15 bis 35 Gew.-% eines Gemischs mindestens zweier organischer Lösemittel, welches 30 bis ≤ 70 Gew.-%, bevorzugt 30 bis ≤ 65 Gew.-% Adipinsäuredimethylester als eines der organischen Lösemittel und weniger als 30 Gew.-%, bevorzugt weniger als 15 Gew.-% und noch mehr bevorzugt 0 Gew.-% Glutarsäuredimethylester plus Bernsteinsäuredimethylester enthält. Im letzteren, noch mehr bevorzugten Fall beträgt der Anteil von Glutarsäuredimethylester plus Bernsteinsäuredimethylester 0 Gew.-% im Gemisch der mindestens zwei organischen Lösemittel oder, mit anderen Worten, das Gemisch der mindestens zwei organischen Lösemittel ist dann frei von Glutarsäuredimethylester und Bernsteinsäuredimethylester; noch anders ausgedrückt, es wird dann bei der Herstellung der erfindungsgemäßen Metallsinterzubereitung kein Glutarsäuredimethylester und Bernsteinsäuredimethylester verwendet oder als Bestandteil zugesetzt.

Falls neben Adipinsäuredimethylester auch Glutarsäuredimethylester und/oder Bernsteinsäuredimethylester im Lösemittelanteil der erfindungsgemäßen Metallsinterzubereitung enthalten sind, so liegt das Gewichtsverhältnis zwischen diesen Dimethylestern beispielsweise brei ≥ 50 bis ≤ 100 Gew.-%, insbesondere ≥ 70 bis ≤ 100 Gew.-% Adipinsäuredimethylester und entsprechend bei > 0 bis ≤ 50 Gew.-%, insbesondere > 0 bis ≤ 30 Gew.-% Glutarsäuredimethylester plus Bernsteinsäuredimethylester.

Neben Adipinsäuredimethylester und den gegebenenfalls in relativ geringen Mengenanteilen, bevorzugt jedoch nicht enthaltenen Dimethylestern der Glutarsäure bzw. der Bernsteinsäure enthält das Gemisch der mindestens zwei organischen Lösemittel den zur Ergänzung auf 100 Gew.-% fehlenden Mengenanteil mindestens eines weiteren, von den genannten drei Dimethylestern verschiedenen organischen Lösemittels. Dabei handelt es sich insbesondere um für Metallsinterzubereitungen üblicherweise verwendete organische Lösemittel. Beispiele sind Terpineole, N-Methyl-2-pyrrolidon, Ethylenglykol, Dimethylacetamid, 1-Tridecanol, 2-Tridecanol, 3-Tridecanol, 4-Tridecanol, 5-Tridecanol, 6-Tridecanol, Isotridecanol, mit Ausnahme einer Methylsubsitution am vorletzten C-Atom unsubstituierte 1-Hydroxy-C16-C20-alkane wie 16-Methylheptadecan-1-ol, Glycerin, Diethylenglykol, Triethylenglykol und aliphatische, insbesondere gesättigte aliphatische Kohlenwasserstoffe mit 5 bis 32 C-Atomen, mehr bevorzugt 10 bis 25 C-Atomen und noch mehr bevorzugt 16 bis 20 C-Atomen. Solche aliphatischen Kohlenwassertoffe werden beispielsweise von Exxon Mobil unter der Marke Exxsol^{™} D120 oder unter der Marke Isopar M^{™} vertrieben.

Die erfindungsgemäße Metallsinterzubereitung kann 0 bis 12 Gew.-%, vorzugsweise 0,1 bis 12 Gew.-%, mehr bevorzugt 1 bis 10 Gew.-% und noch mehr bevorzugt 2 bis 8 Gew.-% wenigstens eines Metallprecursors (C) enthalten.

Unter Metallprecursor wird im Rahmen der Erfindung eine Verbindung verstanden, die wenigstens ein Metall enthält. Vorzugsweise handelt es sich dabei um eine Verbindung, die sich bei Temperaturen von unter 200°C unter Freisetzung eines Metalls zersetzt. Vorzugsweise wird demnach bei Verwendung eines Metallprecursors beim Sinterprozess in situ ein Metall gebildet. Es kann auf einfache Weise ermittelt werden, ob es sich bei einer Verbindung um einen Metallprecursor handelt. So kann beispielsweise eine Paste, die eine zu testende Verbindung enthält, auf ein Substrat mit einer Silberoberfläche abgeschieden, auf 200 °C erhitzt und bei dieser Temperatur für 20 Minuten belassen werden. Danach wird überprüft, ob sich unter diesen Bedingungen die zu testende Verbindung zu einem Metall zersetzt hat. Hierzu kann beispielsweise vor dem Test der Gehalt der metallhaltigen Pastenbestandteile ausgewogen und daraus die theoretische Masse des Metalls berechnet werden. Nach dem Test wird die Masse des auf dem Substrat abgeschiedenen Materials gravimetrisch bestimmt. Entspricht die Masse des auf dem Substrat abgeschiedenen Materials der theoretischen Masse des Metalls, wobei die üblichen Messabweichungen zu berücksichtigen sind, handelt es sich bei der getesteten Verbindung um einen Metallprecursor.

Gemäß einer bevorzugten Ausführungsform handelt es sich bei dem Metallprecursor um einen endotherm zersetzbaren Metallprecursor. Unter endotherm zersetzbarem Metallprecursor soll ein Metallprecursor verstanden werden, dessen thermische Zersetzung, vorzugsweise unter Schutzgasatmosphäre, einen endothermen Vorgang darstellt. Bei dieser thermischen Zersetzung soll es zur Freisetzung von Metall aus dem Metallprecursor kommen.

Gemäß einer weiteren bevorzugten Ausführungsform weist der Metallprecursor ein Metall auf, das auch im partikelförmigen Metall (A) enthalten ist.

Vorzugsweise umfasst der Metallprecursor als Metall wenigstens ein Element, das aus der Gruppe ausgewählt ist, die aus Kupfer, Silber, Gold, Nickel, Palladium und Platin besteht.

Es kann bevorzugt sein, als Metallprecursor endotherm zersetzbare Carbonate, Lactate, Formiate, Citrate, Oxide oder Fettsäuresalze, vorzugsweise Fettsäuresalze mit 6 bis 24 Kohlenstoffatomen, der genannten Metalle zu verwenden.

In besonderen Ausführungsformen werden als Metallprecursor Silbercarbonat, Silber(I)lactat, Silber(II)-formiat, Silbercitrat, Silberoxid (zum Beispiel AgO oder Ag₂O), Kupfer(II)-lactat, Kupferstearat, Kupferoxide (zum Beispiel Cu₂O oder CuO) oder Goldoxide (zum Beispiel Au₂O oder AuO) eingesetzt.

Gemäß einer besonders bevorzugten Ausführungsform wird als Metallprecursor Silbercarbonat, Silber(I)-oxid oder Silber(II)-oxid verwendet.

Falls vorhanden, liegt der Metallprecursor in der Metallsinterzubereitung vorzugsweise in der Form von Partikeln vor.

Die Metallprecursor-Partikel können die Form von Flakes oder eine sphärische (kugelige) Form aufweisen. Vorzugsweise liegen die Partikel des Metallprecursors als Flakes vor.

Die erfindungsgemäße Metallsinterzubereitung kann ferner 0 bis 10 Gew.-%, vorzugsweise 0 bis 8 Gew.-% wenigstens eines Sinterhilfsmittels (D) enthalten. Beispiele für Sinterhilfsmittel sind organische Peroxide, anorganische Peroxide und anorganische Säuren, wie beispielsweise in WO2011/026623 A1 beschrieben.

Die erfindungsgemäße Metallsinterzubereitung kann neben den vorstehend erläuterten Bestandteilen (A) bis (D) 0 bis 15 Gew.-%, vorzugsweise 0 bis 12 Gew.-%, mehr bevorzugt 0,1 bis 10 Gew.-% eines oder mehrerer weiterer Inhaltsstoffe (E) enthalten. Bei diesen weiteren Inhaltsstoffen kann es sich vorzugsweise um üblicherweise in Metallsinterzubereitungen eingesetzte Inhaltsstoffe handeln. Beispielsweise können in der Metallsinterzubereitung als weitere Inhaltsstoffe Dispersionsmittel, Tenside, Entschäumer, Bindemittel, Polymere wie Cellulosederivate, beispielsweise Methylcellulose, Ethylcellulose, Ethylmethylcellulose, Carboxycellulose, Hydroxypropylcellulose, Hydroxyethylcellulose, Hydroxymethylcellulose, und/oder viskositätssteuernde Mittel enthalten sein.

Die Summe der Gew.-% der Bestandteile (A) bis (E) kann beispielsweise 100 Gew.-%, bezogen auf die erfindungsgemäße Metallsinterzubereitung, d.h. vor ihrer Applikation, betragen. Dementsprechend kann die Herstellung der erfindungsgemäßen Metallsinterzubereitung durch Vermischen der Bestandteile (A) bis (E) erfolgen. Dabei können übliche dem Fachmann bekannte Vorrichtungen verwendet werden, beispielsweise Rührwerke und Dreiwalzwerke.

Die erfindungsgemäße Metallsinterzubereitung kann in einem Sinterverfahren eingesetzt werden. Unter Sintern wird das Verbinden von zwei oder mehr Bauelementen durch Erhitzen unter Vermeidung dessen, dass die Metallpartikel (A) die flüssige Phase erreichen, verstanden.

Das unter Verwendung der erfindungsgemäßen Metallsinterzubereitung durchgeführte Sinterverfahren kann unter Druckanwendung oder drucklos durchgeführt werden. Drucklose Durchführbarkeit des Sinterverfahrens bedeutet, dass trotz Verzichts auf die Anwendung von Druck eine hinreichend feste Verbindung zwischen Bauelementen erzielt wird. Die Möglichkeit, den Sinterprozess drucklos durchzuführen, erlaubt es, druckempfindliche, beispielsweise zerbrechliche oder in ihrem Gefüge mechanisch empfindliche Bauelemente im Sinterverfahren einzusetzen. In ihrem Gefüge mechanisch empfindliche Elektronikbauelemente erleiden bei unzulässiger Druckbelastung elektrische Fehlfunktionen.

Unter dem Verbinden von wenigstens zwei Bauelementen wird das Befestigen von einem ersten Bauelement auf einem zweiten Bauelement verstanden. In diesem Zusammenhang bedeutet "auf" lediglich, dass eine Oberfläche des ersten Bauelements mit einer Oberfläche des zweiten Bauelements verbunden wird, wobei es auf die relative Lage der beiden Bauelemente oder der Anordnung, die die wenigstens zwei Bauelemente enthält, nicht ankommt.

Im Rahmen der Erfindung soll der Begriff Bauelement vorzugsweise Einzelteile umfassen. Diese Einzelteile sind vorzugsweise nicht weiter zerlegbar.

Gemäß besonderen Ausführungsformen werden als Bauelemente Teile bezeichnet, die in der Elektronik verwendet werden.

Demgemäß kann es sich bei den Bauelementen beispielsweise um Dioden, LEDs (light emitting diodes, lichtemittierende Dioden), DCB (direct copper bonded)-Substrate, Leadframes, Dies, IGBTs (insulated-gate bipolar transistors, Bipolartransistoren mit isolierter Gate-Elektrode), ICs (integrated circuits, integrierte Schaltungen), Sensoren, Kühlkörper (vorzugsweise Aluminium-Kühlkörper oder Kupfer-Kühlkörper) oder andere passive Baulemente (zum Beispiel Widerstände, Kondensatoren oder Spulen) handeln.

Die zu verbindenden Bauelementen können gleichartige oder verschiedenartige Bauelemente sein.

Ausführungsformen der Erfindung betreffen die Verbindung von LED mit Leadframe, von LED mit keramischem Substrat, von Dies, Dioden, IGBTs oder ICs mit Leadframes, keramischen Substraten oder DCB-Substraten, von Sensor mit Leadframe oder keramischem Substrat. Die Verbindung kann beispielsweise zwischen Aluminium-, Kupfer- oder Silberkontaktflächen der Elektronikbauelemente mit Aluminium-, Kupfer- oder Silberkontaktflächen der Substrate erfolgen, d.h. es kann zur Ausbildung beispielsweise einer Aluminium-Kupfer-, Aluminium-Silber-, Aluminium-Aluminium-, Kupfer-Silber-, Kupfer-Kupfer- oder Silber-Silber-Verbindung kommen. Die hier verwendeten Begriffe "Aluminium-, Kupfer- und Silberkontaktflächen" schließen Kontaktflächen aus Aluminium-, Kupfer- und Silberlegierungen ein.

Die Bauelemente, beispielsweise wenigstens eines der Bauelemente 1 und 2, können - soweit sie nicht ohnehin aus Metall bestehen - wenigstens eine Metallkontaktfläche beispielsweise in Form einer Metallisierungsschicht, insbesondere eine Metallkontaktfläche aus einem unedlen Metall wie Kupfer oder Aluminium umfassen, worüber die schon erwähnte Sandwichanordnung im Rahmen des erfindungsgemäßen Verfahrens erfolgt. Diese Metallisierungsschicht ist vorzugsweise Teil des Bauelements. Die Metallisierungsschicht befindet sich vorzugsweise an wenigstens einer Oberfläche des Bauelements.

Bevorzugt wird die Verbindung der Bauelemente mittels der erfindungsgemäßen Metallsinterzubereitung über besagte Metallisierungsschicht bzw. -schichten vorgenommen.

Die Metallisierungsschicht kann reines Metall aufweisen. So kann es bevorzugt sein, wenn die Metallisierungsschicht wenigstens 50 Gew.-%, mehr bevorzugt wenigstens 70 Gew.-%, noch mehr bevorzugt wenigstens 90 Gew.-% oder aber 100 Gew.-% an reinem Metall aufweist. Das reine Metall ist beispielsweise aus der Gruppe ausgewählt, die aus Aluminium, Kupfer, Silber, Gold, Palladium und Platin besteht.

Andererseits kann die Metallisierungsschicht auch eine Legierung aufweisen. Die Legierung der Metallisierungsschicht enthält vorzugsweise wenigstens ein Metall, das aus der Gruppe ausgewählt ist, die aus Aluminium, Silber, Kupfer, Gold, Nickel, Palladium und Platin besteht.

Die Metallisierungsschicht kann auch einen mehrlagigen Aufbau aufweisen. So kann es beispielsweise bevorzugt sein, wenn wenigstens eine Oberfläche der zu verbindenden Bauelemente eine Metallisierungsschicht aus mehreren Lagen umfasst, die die vorstehend genannten reinen Metalle und/oder Legierungen aufweisen.

Im erfindungsgemäßen Verfahren werden wenigstens zwei Bauelemente durch Sintern miteinander verbunden.

Dazu werden zunächst die zwei oder mehr Bauelemente miteinander in Kontakt gebracht. Das Kontaktieren erfolgt dabei über die erfindungsgemäße Metallsinterzubereitung. Zu diesem Zweck wird eine Anordnung bereitgestellt, bei der sich zwischen jeweils zwei der wenigstens zwei Bauelemente erfindungsgemäße Metallsinterzubereitung befindet.

Sollen daher zwei Bauelemente, Bauelement 1 und Bauelement 2, miteinander verbunden werden, so befindet sich die erfindungsgemäße Metallsinterzubereitung vor dem Sintern zwischen Bauelement 1 und Bauelement 2. Andererseits ist es denkbar, dass mehr als zwei Bauelemente miteinander verbunden werden. Beispielsweise können drei Bauelemente, Bauelement 1, Bauelement 2 und Bauelement 3, auf eine Weise miteinander verbunden werden, dass Bauelement 2 zwischen Bauelement 1 und Bauelement 3 liegt. In diesem Fall befindet sich die erfindungsgemäße Metallsinterzubereitung sowohl zwischen Bauelement 1 und Bauelement 2 als auch zwischen Bauelement 2 und Bauelement 3.

Die einzelnen Bauelemente liegen in einer Sandwichanordnung vor und werden miteinander verbunden. Unter Sandwichanordnung ist eine Anordnung zu verstehen, bei der sich zwei Bauelemente übereinander befinden und die Bauelemente im Wesentlichen parallel zueinander angeordnet sind.

Die Anordnung aus wenigstens zwei Bauelementen und erfindungsgemäßer Metallsinterzubereitung, wobei sich die Metallsinterzubereitung zwischen zwei Bauelementen dieser Anordnung befindet, kann nach einem aus dem Stand der Technik bekannten Verfahren hergestellt werden.

Vorzugsweise wird zunächst wenigstens eine Oberfläche eines Bauelements 1 mit der erfindungsgemäßen Metallsinterzubereitung versehen. Anschließend wird ein anderes Bauelement 2 mit einer seiner Oberflächen auf die Metallsinterzubereitung, die auf die Oberfläche des Bauelements 1 aufgetragen worden ist, aufgesetzt.

Die Auftragung der erfindungsgemäßen Metallsinterzubereitung auf die Oberfläche eines Bauelements kann mittels herkömmlicher Verfahren erfolgen, beispielsweise mittels Dispenstechnik oder Druckverfahren wie Siebdruck oder Schablonendruck oder auch mittels anderer Auftragstechniken wie beispielsweise Sprühauftrag, Pintransfer oder Dippen.

Im Anschluss an die Auftragung der erfindungsgemäßen Metallsinterzubereitung wird vorzugsweise die mit der Metallsinterzubereitung versehene Oberfläche dieses Bauelements mit einer Oberfläche des damit zu verbindenden Bauelements über die Metallsinterzubereitung in Kontakt gebracht. Somit befindet sich zwischen den zu verbindenden Bauelementen eine Schicht erfindungsgemäße Metallsinterzubereitung.

Die Nassschichtdicke zwischen den zu verbindenden Bauelementen liegt vorzugsweise im Bereich von 20 bis 100 µm. Unter Nassschichtdicke wird hier der Abstand zwischen den einander gegenüberliegenden Oberflächen der zu verbindenden Bauelemente vor einem gegebenenfalls stattfindenden Trocknen und vor dem Sintern verstanden. Die bevorzugte Nassschichtdicke ist abhängig vom gewählten Verfahren zum Auftragen der Metallsinterzubereitung. Wird die Metallsinterzubereitung beispielsweise mittels Siebdruckverfahren aufgetragen, dann kann eine Nassschichtdicke von 20 bis 50 µm bevorzugt sein. Erfolgt die Auftragung der Metallsinterzubereitung mittels Schablonendruck, dann kann die bevorzugte Nassschichtdicke im Bereich von 20 bis 100 µm liegen. Bei der Dispenstechnik kann die bevorzugte Nassschichtdicke im Bereich von 20 bis 100 µm liegen.

Optional kann vor dem Sintern ein Trocknungsschritt durchgeführt werden, d.h. eine Entfernung von organischem Lösemittel aus der applizierten Metallsinterzubereitung. Gemäß einer bevorzugten Ausführungsform liegt der Anteil an organischem Lösemittel in der Metallsinterzubereitung nach der Trocknung beispielsweise bei 0 bis 5 Gew.-%, bezogen auf den ursprünglichen Anteil an organischem Lösemittel in der erfindungsgemäßen Metallsinterzubereitung, d.h. applikationsbereiten Metallsinterzubereitung. Mit anderen Worten, gemäß dieser bevorzugten Ausführungsform werden beispielsweise 95 bis 100 Gew.-% der ursprünglich in der erfindungsgemäßen Metallsinterzubereitung enthaltenen organischen Lösemittel bei der Trocknung entfernt.

Findet ein Trocknen statt, so kann die Trocknung im Falle des drucklosen Sinterns nach der Herstellung der Anordnung, also nach der Kontaktierung der zu verbindenden Bauelemente erfolgen. Im Falle des Drucksinterns kann die Trocknung auch nach dem Auftragen der Metallsinterzubereitung auf die wenigstens eine Oberfläche des Bauelements und vor der Kontaktierung mit dem zu verbindenden Bauelement erfolgen.

Die Trocknungstemperatur liegt vorzugsweise im Bereich von 100 bis 180 °C.

Es versteht sich, dass die Trocknungszeit abhängig ist von der Zusammensetzung der erfindungsgemäßen Metallsinterzubereitung und der Größe der Verbindungsfläche der zu sinternden Anordnung. Übliche Trocknungszeiten liegen im Bereich von 5 bis 45 Minuten.

Die Anordnung aus den wenigstens zwei Bauelementen und zwischen den Bauelementen befindlicher Metallsinterzubereitung wird schließlich einem Sinterprozess unterworfen.

Das eigentliche Sintern erfolgt bei einer Temperatur von beispielsweise 200 bis 280 °C entweder als druckloser Prozess oder als Drucksintern.

Beim Drucksintern liegt der Prozessdruck vorzugsweise unter 30 MPa und mehr bevorzugt unter 5 MPa. Beispielsweise liegt der Prozessdruck im Bereich von 1 bis 30 MPa und mehr bevorzugt im Bereich von 1 bis 5 MPa.

Die Sinterzeit liegt beispielsweise im Bereich von 2 bis 60 Minuten, beim Drucksintern beispielsweise im Bereich von 2 bis 5 Minuten, beim Drucklossintern beispielsweise im Bereich von 30 bis 60 Minuten.

Der Sinterprozess kann in einer Atmosphäre erfolgen, die keinen besonderen Beschränkungen unterliegt. So kann das Sintern einerseits in einer Atmosphäre durchgeführt werden, die Sauerstoff enthält. Andererseits ist es auch möglich, das Sintern in sauerstofffreier Atmosphäre durchzuführen. Unter sauerstofffreier Atmosphäre ist im Rahmen der Erfindung eine Atmosphäre zu verstehen, deren Sauerstoffgehalt nicht mehr als 10 ppm, vorzugsweise nicht mehr als 1 ppm und noch mehr bevorzugt nicht mehr als 0,1 ppm beträgt.

Das Sintern wird in einer herkömmlichen, zum Sintern geeigneten Vorrichtung durchgeführt, in der sich die vorstehend beschriebenen Prozessparameter einstellen lassen.

Die Erfindung wird im Folgenden anhand von Beispielen erläutert, die jedoch nicht als einschränkend verstanden werden sollen.

### Beispiele:

1. Herstellung von Silbersinterzubereitungen:
Zunächst wurden die erfindungsgemäße Silbersinterzubereitung 1 und die Vergleichszubereitungen 2 bis 4 durch Vermischen der einzelnen Bestandteile gemäß nachfolgender Tabelle hergestellt. Alle Mengenangaben bedeuten Gew.-%.

| Zubereitung | 1 | 2 | 3 | 4 |
|---|---|---|---|---|
| Silberpartikel ¹⁾ | 75,9 | 75,9 | 75,9 | 75,9 |
| Silbercarbonat | 3,2 | 3,2 | 3,2 | 3,2 |
| α-Terpineol | 9,1 | 9,1 | 9,1 | 9,1 |
| Adipinsäuredimethylester | 11,8 | | | |
| Glutarsäuredimethylester | | 11,8 | | |
| Bernsteinsäuredimethylester | | | 11,8 | |
| Coasol™ | | | | 11,8 |
| Summe | 100 | 100 | 100 | 100 |

| | | | | |
|---|---|---|---|---|
| ¹⁾ Silberflakes mit einem mittleren Teilchendurchmesser (d50) von 4,50 µm und einem Fettsäurecoating von 0,7 Gew.-% | | | | |

2. Applikation und druckloses Sintern der Silbersinterzubereitungen:
Die jeweilige Silbersinterzubereitung wurde mittels Dispensen auf die Goldoberfläche eines mit einer Gold/Nickel-Schicht versehenen DCB-Substrats in einer Nassschichtdicke von 50 µm appliziert. Anschließend wurde die applizierte Silbersinterzubereitung ohne vorherige Trocknung mit einem Siliziumchip mit Silberkontaktfläche (2 · 2 mm²) in Kontakt gebracht. Das anschließende drucklose Sintern erfolgte nach folgendem Aufwärmprofil: Innerhalb von 60 Minuten wurde die Kontaktstelle kontinuierlich auf 200 °C erwärmt und für 30 Minuten bei 200 °C gehalten.
Anschließend wurde die Temperatur innerhalb von 15 Minuten kontinuierlich auf 280 °C erhöht und 60 Minuten gehalten. Dann wurde innerhalb von 50 Minuten kontinuierlich auf 30 °C abgekühlt.

Nach dem Sintern wurde die Haftung über die Scherfestigkeit bestimmt. Dabei wurden die Bauelemente mit einem Schermeißel bei einer Geschwindigkeit von 0,3 mm/s bei 20 °C abgeschert. Die Kraft wurde mittels einer Kraftmessdose aufgenommen (Gerät DAGE 2000 der Firma DAGE, Deutschland). Tabelle 2 zeigt die mit den Silbersinterzubereitungen 1 bis 4 erhaltenen Ergebnisse.

**Tabelle 2:**

| Zubereitung | 1 | 2 | 3 | 4 |
|---|---|---|---|---|
| Scherfestigkeit bei 20°C (N/mm²) | 16,9 | 9,8 | 4,8 | 13,7 |

## Patentansprüche

1. Metallsinterzubereitung, die (A) 50 bis 90 Gew.-% wenigstens eines Metalls, das in Form von Partikeln vorliegt, die ein Coating aufweisen, das wenigstens eine organische Verbindung enthält, und (B) 6 bis 50 Gew.-% eines Gemischs mindestens zweier organischer Lösemittel umfasst,
**dadurch gekennzeichnet,**
**dass** das Lösemittelgemisch (B) 30 bis ≤ 70 Gew.-% Adipinsäuredimethylester als eines der organischen Lösemittel und weniger als 30 Gew.-% Glutarsäuredimethylester plus Bernsteinsäuredimethylester enthält.

2. Metallsinterzubereitung nach Anspruch 1,
wobei das Gemisch der mindestens zwei organischen Lösemittel (B) frei ist von Glutarsäuredimethylester und Bernsteinsäuredimethylester.

3. Metallsinterzubereitung nach Anspruch 1 oder 2,
wobei das wenigstens eine Metall ausgewählt ist aus der aus Kupfer, Silber, Gold, Nickel, Palladium, Platin und Aluminium bestehenden Gruppe.

4. Metallsinterzubereitung nach einem der vorhergehenden Ansprüche,
wobei die Metallpartikel die Form von Flakes aufweisen.

5. Metallsinterzubereitung nach einem der vorhergehenden Ansprüche, wobei die wenigstens eine organische Verbindung ausgewählt ist aus der aus freien Fettsäuren, Fettsäuresalzen und Fettsäureestern bestehenden Gruppe.

6. Metallsinterzubereitung nach einem der Ansprüche 1 oder 3 bis 5,
wobei das Gemisch der mindestens zwei organischen Lösemittel (B) Adipinsäuredimethylester und Glutarsäuredimethylester und/oder Bernsteinsäuredimethylester im Gewichtsverhältnis ≥ 50 bis ≤ 100 Gew.-% Adipinsäuredimethylester : > 0 bis ≤ 50 Gew.-% Glutarsäuredimethylester plus Bernsteinsäuredimethylester enthält.

7. Metallsinterzubereitung nach einem der vorhergehenden Ansprüche, wobei das Gemisch der mindestens zwei organischen Lösemittel (B) den zur Ergänzung auf 100 Gew.-% fehlenden Mengenanteil mindestens eines weiteren, von Adipinsäuredimethylester, Glutarsäuredimethylester und Bernsteinsäuredimethylester verschiedenen organischen Lösemittels in Form eines aus der Terpineole, N-Methyl-2-pyrrolidon, Ethylenglykol, Dimethylacetamid, 1-Tridecanol, 2-Tridecanol, 3-Tridecanol, 4-Tridecanol, 5-Tridecanol, 6-Tridecanol, Isotridecanol, mit Ausnahme einer Methylsubsitution am vorletzten C-Atom unsubstituierte 1-Hydroxy-C16-C20-alkane, Glycerin, Diethylenglykol, Triethylenglykol und aliphatische Kohlenwasserstoffe mit 5 bis 32 C-Atomen umfassenden Gruppe ausgewählten organischen Lösemittels umfasst.

8. Metallsinterzubereitung nach einem der vorhergehenden Ansprüche, enthaltend neben den Bestandteilen (A) und (B) 0 bis 12 Gew.-% wenigstens eines Metallprecursors (C), 0 bis 10 Gew.-% wenigstens eines Sinterhilfsmittels (D) und 0 bis 15 Gew.-% eines oder mehrerer weiterer Inhaltsstoffe (E) ausgewählt unter Dispersionsmitteln, Tensiden, Entschäumern, Bindemitteln, Polymeren und/oder viskositätssteuernden Mitteln.

9. Verfahren zum Verbinden von Bauelementen, bei dem man (a) eine Sandwichanordnung bereitstellt, die wenigstens (a1) ein Bauelement 1, (a2) ein Bauelement 2 und (a3) eine Metallsinterzubereitung nach einem der vorhergehenden Ansprüche aufweist, die sich zwischen Bauelement 1 und Bauelement 2 befindet, und (b) die Sandwichanordnung sintert.

10. Verfahren nach Anspruch 9,
wobei wenigstens eines der Bauelemente 1 und 2 eine Aluminium- oder Kupferkontaktfläche aufweist, über die die Sandwichanordnung erfolgt.

11. Verfahren nach Anspruch 9 oder 10,
wobei man unter Druckanwendung oder drucklos sintert.

12. Verfahren nach einem der Ansprüche 9 bis 11,
wobei es sich bei den Bauelementen um in der Elektronik verwendete Teile handelt.
